Europäisches Patentamt

**European Patent Office**

Office européen des brevets

(19)

(11) Numéro de publication: **0 101 774**
**B1**

(12)

# FASCICULE DE BREVET EUROPEEN

(45) Date de publication du fascicule du brevet:
**14.05.86**

(51) Int. Cl.⁴: **H 01 J 37/32,** H 02 H 9/02

(21) Numéro de dépôt: **82420125.5**

(22) Date de dépôt: **26.08.82**

(54) Alimentation électrique de sécurité pour décharge luminescente.

(43) Date de publication de la demande:
**07.03.84 Bulletin 84/10**

(45) Mention de la délivrance du brevet:
**14.05.86 Bulletin 86/20**

(84) Etats contractants désignés:
**CH DE GB IT LI SE**

(56) Documents cités:
**DE - A - 2 941 339**
**FR - A - 1 266 098**
**FR - A - 1 466 995**
**FR - A - 1 541 370**

(73) Titulaire: **CENTRE STEPHANOIS DE RECHERCHES**
**MECANIQUES HYDROMECANIQUE ET FROTTEMENT**
**Société dite:, Zone Industrielle Sud Rue Benoît**
**Fourneyron, F-42160 Andrezieux Boutheon (FR)**

(72) Inventeur: **Terrat, Jean-Paul, 10 Rue Etienne Boisson,**
**F-42000 Saint Etienne (FR)**

(74) Mandataire: **Maisonnier, Jean, Bureau**
**Maisonnier 28 Rue Servient, F-69003 Lyon (FR)**

ACTORUM AG

**Description**

De nombreuses industries utilisent des décharges luminescentes en atmosphère raréfiée. C'est le cas de l'industrie des traitements de surface qui voit la palette des techniques utilisables s'enrichir de procédés tels que la pulvérisation cathodique magnétron ou le dépôt ionique qui, jusque là, n'avaient pas quitté le stade des essais de laboratoire. Or, si l'on sait bien, dans de nombreux cas, mettre en oeuvre des décharges électriques sous atmosphère raréfiée, il n'en est pas de même avec les deux techniques mentionnées plus haut, pour lesquelles le material de mise en oeuvre habituellement utilisé ne répond que très imparfaitement aux besoins.

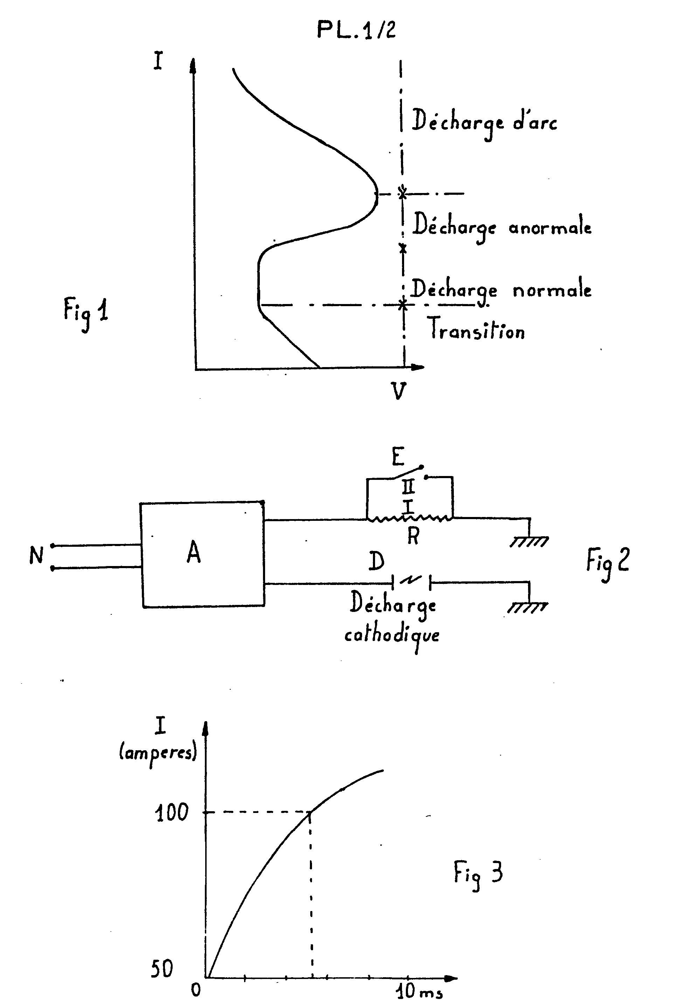

En effet, lorsqu'on établit, dans une atmosphère raréfiée une tension de valeur suffisante entre deux électrodes, il se produit une ionisation partielle du gaz résiduel, rendant celui-ci conducteur, ce qui se traduit par le passage d'un courant électrique. Si l'on fait varier la tension V appliquée entre ces électrodes en mesurant l'intensité I du courant correspondant, on obtient la courbe «tension-intensité» représentée ci-joint sur la figure 1, et dans laquelle on distingue successivement quatre portions très caractéristiques:
— une portion correspondant à une transition;
— une portion correspondant à la «décharge normale» dans laquelle la tension reste constante, le rapport V/I étant indéterminé entre deux valeurs extrèmes;
— une portion correspondant à la «décharge anormale» dans laquelle tension et intensité croissent de façon concomitante;
— enfin une portion correspondant à l'établissement du «régime d'arc»: l'atmosphère, fortement ionisée, devient conductrice; il y a passage d'un courant intense sous faible tension.

Lorsqu'on fait de la Pulvérisation Cathodique Magnétron ou du Dépôt Ionique, on travaille généralement dans le domaine de «décharge anormale». Pour une raison généralement extérieure à l'alimentation électrique (par exemple poussières sur l'électrode, points chauds, arêtes vives, oxydes peu conducteurs), le régime de cette décharge anormale est fréquemment difficile à stabiliser et l'on observe une tendance à établir un «régime d'arc»; ce sont les amorçages, particulièrement gênants pour la qualité des dépôts mis en oeuvre par ces techniques.

Dans l'état actuel de la technologie, la décharge est générée et entretenue par un système d'alimentation de courant qui comprend deux sous-ensembles fondamentaux:
— l'un délivre l'intensité requise: c'est le «circuit de puissance» dans lequel est incluse en particulier la régulation de l'intensité ou de la tension;
— l'autre permet de contrôler cette régulation: c'est le «circuit» de commande.

Le circuit de puissance a pour fonction de fournir, à partir du courant du secteur, un courant généralement continu, d'intensité ou de tension régulée et ajustable à une valeur fixée à l'avance:
— pour les cas d'amorçages ou de court-circuit, le circuit de puissance est généralement doté d'une self dite «self de choc» dont le rôle, par le jeu des courants qui y sont induits, est d'écréter le pic d'intensité correspondant à cette anomalie de fonctionnement
— pour les cas où le court-circuit se prolonge, un relais ouvre alors le circuit de commande, ce qui a pour effet de couper le circuit de puissance (voir par exemple FR-A 1 541 370).

Pour la régulation du circuit de puissance, deux solutions classiques sont utilisées à l'heure actuelle:
— soit la régulation par thyristors;
— soit la régulation dite «par self saturable».

Dans tous les cas, ce circuit de puissance comporte un ou plusieurs transformateurs destinés à débiter le courant de travail de caractéristiques voulues à partir d'une alimentation secteur.

Par le fait que, dans le cas général, le circuit comporte au moins un transformateur, le circuit de puissance comporte des bobinages introduisant une inertie importante au moment de l'ouverture du circuit, de sorte que lorsqu'un amorçage déclenche le relais ouvrant le circuit de commande, le courant continue quand même à circuler dans le circuit de puissance pendant quelques millisecondes. Et cette durée est suffisante pour entraîner parfois des détériorations irréversibles dans le matériel, particulièrement au niveau des diodes de redressement, qui doivent donc être fortement surdimensionnées ce qui est relativement facile à réaliser pour des alimentations de faible puissance, mais devient plus délicat pour les alimentations de puissance élevée. L'utilisation d'une «self de choc» placée en série dans le circuit résout partiellement le problème mais dès que la puissance délivrée est élevée, cette self de choc est telle que ses dimensions et son poids deviennent rapidement très élevés ce qui est un inconvénient pour l'utilisateur.

Le but de la présente invention est, conformément à la revendication 1, d'établir la déchage luminescente de forte puissance à l'aide d'un système que l'on appellera par la suite l'Invention, composé obligatoirement et de façon indissociable:
— d'une alimentation électrique stabilisée A;
— d'un interrupteur électronique E;
— d'une résistance R,
assemblés conformément au schema de la figure 2. Le circuit électrique qui relie l'alimentation aux pièces à polariser se scinde en deux branches I et II parallèles, l'une constituée de la résistance R, l'autre de l'interrupteur E.

Par ailleurs, l'ouverture et la fermeture de cet interrupteur sont commandées par un système électronique asservi à la mesure de l'intensité du courant délivré par l'alimentation A.

Conformement à l'Invention, et pour préciser celle-ci:
— l'alimentation utilisée ne comporte pas de «self de choc» qui devient inutile,
— l'invention s'applique aussi bien à l'utilisation d'alimentations délivrant un courant d'intensité régulée ou de tension régulée;
ce courant peut être continu ou modulé,
— l'interrupteur E utilisé a un temps de réponse très bref, dans tous les cas inférieur à une milliseconde;
— la résistance R est calculée de telle sorte que l'impédance de la branche de circuit qu'elle constitue soit voisine de celle de la branche de circuit constituée par la décharge électrique; et dans le cas où le courant fourni par l'alimentatiom est modulé, cette impédance doit être d'origine résistive pour au moins 80% de sa valeur.

L'Invention sera expliquée en se référant aux figures 1 à 5.

Le fonctionnement de l'Invention est le suivant:

— en service normal, c'est-à-dire lorsqu'on est dans le domaine de la «décharge anormale», l'interrupteur E est fermé. La résistance de la branche I est infiniment plus grande que celle de la branche II qui reçoit donc la totalité du courant électrique;

— en cas d'amorçage, c'est-à-dire de passage brutal dans le «régime d'arc», il y a un accroissement subit de l'intensité du courant lorsque celle-ci dépasse une valeur de consigne fixée à l'avance, l'interrupteur E s'ouvre et, la branche II du circuit étant ouverte, la résistance R est alors en série avec l'alimentation et limite la croissance de l'intensité débitée par celle-ci. L'utilisation, d'un interrupteur à transistors permet de ne pas dépasser une durée de quelques microsecondes entre le début de l'amorçage de l'arc et l'ouverture du circuit.

De préférence, on choisit pour la resistance R, une valeur telle que l'impédance de la branche de circuit qu'elle représente soit égale à l'impédance de la branche de circuit D constituée par la décharge électrique en régime de «décharge anormale».

Les avantages d'un tel système sont nombreux. En particulier, la disposition revendiquée pour les trois composants permet une élimination totale des arcs, d'où une sécurité absolue d'une part sur les composants de l'alimentation, d'autre part sur la qualité des revêtements réalisés, enfin sur les pièces à traiter elles-mêmes, et ceci sans augmentation notable de poids et de l'encombrement de l'alimentation.

Cette élimination des arcs se traduit par une meilleure régulation du courant fourni par le circuit de puissance. Par ailleurs, les composants de l'invention peuvent être trouvés facilement dans le commerce, même pour des puissances élevées, et en particulier, l'Invention peut s'adapter à toutes les alimentations classiques dont le fonctionnement et la fiabilité se trouvent alors considérablement améliorés.

Les exemples suivants, non limitatifs, permettent d'illustrer l'Invention et ses avantages:

*Exemple 1*

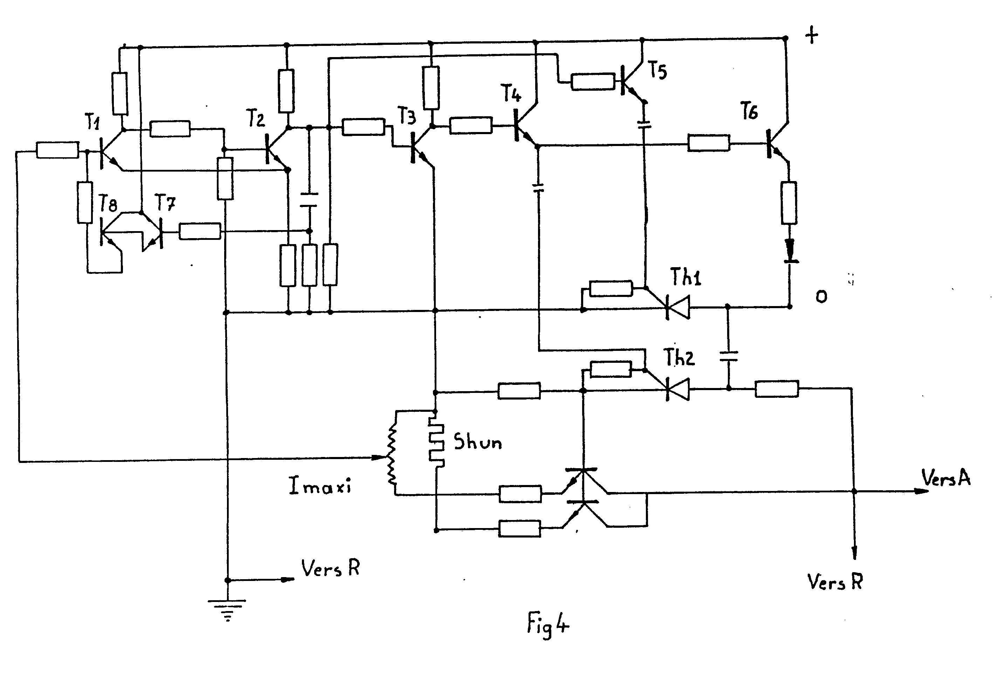

Pour réaliser certains dépôts de titane sur une pièce en acier par Pulvérisation Cathodique Rapide (système Magnétron), on a utilisé une alimentation stabilisée de courant continu délivrant une intensité de 50 ampères sous une tension de quelques centaines de volts; l'intensité du courant était régulée à 2% près par un système à self saturable, et l'intensité maximale que pouvaient supporter les composants était de 100 ampères. Cette alimentation était associée à une cible en titane pur et lorsque la décharge était stable, l'impédance du circuit qu'elle constituait était de 7 ohms. Chaque fois que le cible était neuve, on constatait qu'il était très difficile d'établir une décharge électrique qui restât stable. En particulier, on observait la formation incessante d'arcs électriques dont l'intensité mesurée à l'oscilloscope pouvait déjà atteindre 100 ampères en cinq millisecondes tandis que la coupure réelle du courant n'avait lieu que neuf millisecondes après l'amorçage de l'arc, comme le montre la courbe de la figure 3. Ces surintensités étaient à l'origine de fréquentes perturbations dans le fonctionnement de l'alimentation et en particulier de la destruction des diodes de redressement car la valeur maximale de 100 ampères était fréquemment dépassée pendant de courts instants et ceci tant que la cible n'avait pas atteint un état de surface adéquat. Selon l'Invention, on a ensuite utilisé l'interrupterur électronique dont le schéma est représenté figure 4 et on l'a associé avec l'alimentation décrite ci-dessus, et une résistance de 6 ohms conformément au schéma de branchement de la figure 2; on a alors constaté que lors des amorçages d'arcs, le courant passait de 50 à 51 ampères, puis se stabilisait et ceci trois microsecondes après établissement de l'arc. Dès que les arcs étaient coupés, une temporisation permettait de mettre la résistance hors série en fermant l'interrupteur.

*Exemple 2*

Dans une machine de dépôt utilisant la technique du Dépôt Ionique, on doit polariser'les pièces à traiter sous une tension de 1100 volts dans un vide de 10 Pa (10$^{-1}$ mbar), en atmosphère d'argon, ce qui correspond à une intensité de 2,3 ampères. Dans la version classique, on utilisait pour cela une alimentation stabilisée donnant une tension régulée par un système à thyristors et réglable entre 0 et 5000 volts. Cette alimentation pouvait fournir un courant d'intensité maximale égale à 10 ampères.

Pour effectuer ce dépôt, il était nécessaire d'établir la décharge avant de commencer l'évaporisation, de façon à réaliser un décapage ionique des pièces à traiter. Pour ce faire, on constatait qu'il était impossible d'appliquer directement les 1100 volts, sans amorçages importants. L'intensité mesurée à l'oscilloscope pendant l'amorçage de l'arc pouvait dépasser 50 ampères, dix millisecondes après le début de l'amorçage. Outre des conséquences désastreuses sur l'alimentation elle-même, ces amorçages entraînaient une dégradation de l'état de surface des pièces à traiter, de telle sorte que l'on était obligé de faire une montée en tension très lente entre 0 et 3000 volts, ce qui imposait une perte de temps importante sans éliminer les risques.

Enfin, lorsque le décharge était stable, l'impédance de la portion de circuit qu'elle constituait était de 480 ohms.

Si maintenant, et conformement à l'Invention, on réalise un interrupteur électronique tel que celui représenté sur le schéma électrique de la figure 4 et qu'on l'associe à une résistance de 500 ohms et à l'alimentation stabilisée décrite ci-dessus, on constate que l'opérateur peut, dès le début des opérations, afficher la tension de 1100 volts qui sera délivrée par l'alimentation. Si on mesure les variations de l'intensité du courant à l'aide d'un oscilloscope, on s'aperçoit que lorsqu'un arc s'amorce, le courant passe de 2,3 à 2,45 ampères et ceci en 12 millisecondes, laps de temps à partir duquel la résistance est introduite en série dans le circuit et le courant reste constant à sa valeur de 2,45 ampères; les pièces ainsi traitées conservent leur état initial et en particulier, on n'observe aucune formation de cratères.

## Revendications

1. Dispositif d'alimentation électrique de sûreté pour décharge luminescente, caractérisé en ce qu'il comprend une alimentation de puissance A reliée aux pièces à polariser par un circuit électrique comprenant un interrupteur E à réponse rapide et une résistance R en parallèle, l'ouverture et la fermeture de l'interrupteur E, destinées à mettre la résistance R en série avec l'alimentation A, ou à l'en ôter, respectivement, étant commandées par un système électronique asservi à la mesure de l'intensité du courant délivré par ladite alimentation A.

2. Dispositif d'alimentation électrique de sûreté pour décharge luminescente suivant la revendication 1, caractérisé en ce que l'interrupteur E a un temps de réponse inférieur à une milliseconde.

3. Dispositif d'alimentation électrique de sûreté pour décharge luminescente suivant les revendications 1 et 2, caractérisé en ce que l'interrupteur E est constitué par un système électronique à transistors.

4. Dispositif d'alimentation électrique de sûreté pour décharge luminescente suivant les revendications 1, 2 et 3, caractérisé en ce que l'interrupteur électronique E a un temps de réponse inférieur à 15 microsecondes.

5. Dispositif d'alimentation électrique de sûreté pour décharge luminescente suivant l'une quelconque des revendications précédentes, caractérisé en ce que le courant délivré par l'alimentation A est un courant continu.

6. Dispositif d'alimentation électrique de sûreté pour décharge liminescente suivant l'une quelconque des revendications 1 à 4, caractérisé en ce que le courant délivré par l'alimentation A est un courant modulé.

7. Dispositif d'alimentation électrique pour décharge luminescente suivant l'une quelconque des revendications précédentes, caractérisé en ce que la résistance R est calculée de façon telle que l'impédance de la branche de circuit qu'elle représente est égale à l'impédance de la branche de circuit D constituée par la décharge électrique en régime de «décharge anormale».

8. Dispositif d'alimentation électrique pour décharge luminescente suivant l'une quelconque des revendications 1 à 7, caractérisé en ce que l'impédance de la branche de circuit constituée par la résistance R est d'origine résistive pour au moins 80% de sa valeur.

## Patentansprüche

1. Sicherheitsvorrichtung zur elektrischen Zuleitung von einem Glimmentladungapparat, dadurch gekennzeichnet, dass sie daraus besteht: durch einen Eingangskreis mit den zu vorspannen Bestandelementen verbundene Leistungszuleitung A; Schnellausschalter B; Parallelwiderstand R; wobei in Abhängigkeit mit der Stromstärke wird, durch Aufschaltung des Schalters B der Widerstand R in Serie mit der Leistungzuleitung A eingeschaltet, während durch Zuschaltung des Schalters B wird der Widerstand R ausgeschaltet.

2. Sicherheitsvorrichtung gemäss Patentanspruch 1, dadurch gekennzeichnet, dass die Ansprechzeit des Schnellausschalters E weniger als 1 ms. ist.

3. Sicherheitsvorrichtung gemäss Patentansprüchen 1 und 2, dadurch gekennzeichnet, dass der Schnellausschalter E aus elektronische Transistorkomponente besteht.

4. Sicherheitsvorrichtung gemäss Patentansprüchen 1, 2 und 3, dadurch gekennzeichnet, dass die Ansprechzeit des elektronischen Ausschalters E weniger als 15 Mikrosekunden ist.

5. Sicherheitsvorrichtung gemäss einer der Patentansprüchen 1 bis 4, dadurch gekennzeichnet, dass durch Leistungszuleitung A Gleichstrom zugeleitet wird.

6. Sicherheitsvorrichtung gemäss einer der Patentansprüchen 1 bis 4, dadurch gekennzeichnet, dass durch Leistungszuleitung A Modulationstrom zugeleitet wird.

7. Sicherheitsvorrichtung gemäss einer der Patentansprüchen 1 bis 6, dadurch gekennzeichnet, dass der Kreistel mit Widerstand R die selbe Impedanz hat als der Kreisel D mit der elektrischen Entladung im «Regelwidrigentladungszustand».

8. Sicherheitsvorrichtung gemäss einer der Patentansprüchen 1 bis 7, dadurch gekennzeichnet der Kreistel mit Widerstand R hat eine Impedanz, die mindestens 80% Widerstandimpedanz ist.

## Claims

1. Safety electrical power supply for luminescent discharge in a rarefied atmosphere, characterized in that it is comprising power supply means A connected to components to be biased by means of an electrical circuit including a switch E, with instant response time and a resistance R connected in parallel, said switch E being opened and closed in response to the intensity of the current delivered by said power supply A, in order to selectively interconnect resistance R in series with power supply A, or to disconnect said resistance R.

2. Safety electrical power supply for luminescent discharge according to claim 1, characterized in that the response time of switch E is less than one millisecond.

3. Safety electrical power supply for luminescent discharge according to claims 1 and 2, characterized in that switch E is a transistorized electronical system.

4. Safety electrical power supply for luminescent discharge according to claims 2 and 3, characterized in that electronical switch E has a response time less than 15 microseconds.

5. Safety electrical power supply for luminescent discharge, according to any one of the preceding claims, characterized in that the current delivered by said power supply means A is a direct current.

6. Safety electrical power supply for luminescent discharge according to any one of claims 1 to 4, characterized in that the current delivered by said power supply means A is a modulated current.

7. Safety electrical power supply for luminescent discharge according to any one of the preceding claims characterized in that resistance R is chosen such that the impedance of the circuit branch which said resistor R represents equals the impedance of the circuit branch comprising said discharge means under anormalous discharge conditions.

8. Safety electrical power supply for luminescent discharge according to any one of the claims 1 to 7, characterized in that the impedance of the circuit branch comprising resistor R ist of resistive origin in at least 80% of its value.

PL.1/2

Fig 1

Décharge d'arc

Décharge anormale

Décharge normale

Transition

Fig 2

Décharge cathodique

Fig 3

Fig 4